# EUROPÄISCHE PATENTSCHRIFT

(11) **EP 0 842 073 B1**
(45) Veröffentlichungstag und Bekanntmachung des Hinweises auf die Patenterteilung: **10.05.2000**
(21) Anmeldenummer: 96923879.9
(22) Anmeldetag: 20.06.1996
(51) Int. Cl.: B60T 8/88

(54) **VERFAHREN UND SCHALTUNGSANORDNUNG ZUR ÜBERWACHUNG EINER STEUERSCHALTUNG**
PROCESS AND CIRCUITRY FOR MONITORING A CONTROL CIRCUIT
PROCEDE ET CIRCUITS DE CONTROLE D'UN CIRCUIT DE COMMANDE

(30) Priorität: 10.08.1995 DE 19529433
(43) Veröffentlichungstag der Anmeldung: 20.05.1998
(73) Patentinhaber: Continental Teves AG & Co. oHG, 60488 Frankfurt (DE)
(72) Erfinder: ENGELMANN, Mario, D-61449 Steinbach (DE); ZYDEK, Michael, D-35428 Langgöns (DE); ZINKE, Olaf, D-65719 Hofheim (DE); FEY, Wolfgang, D-65527 Niedernhausen (DE)
(86) Internationale Anmeldenummer: EP9602689
(87) Internationale Veröffentlichungsnummer: WO9706039

(56) Entgegenhaltungen:
- EP-A- 0 415 039
- WO-A-92/17358

## Beschreibung

Die Erfindung bezieht sich auf ein Verfahren zur Überwachung einer Steuerschaltung, die eine Vielzahl von induktive Lasten schaltende Endstufen aufweist, bei dem der durch die induktive Lasten fließende Strom durch getaktete Ansteuerung der Endstufen geregelt wird, wobei der in den Sperrphasen der Endstufen durch den Abbau der in den induktiven Lasten gespeicherten Energie hervorgerufene Strom über einen zu der Last parallelen, einen Schalter enthaltenden Strompfad geleitet wird. Schaltungsanordnungen zur Durchführung des Verfahrens gehören ebenfalls zur Erfindung.

Aus dem EP-A-0 415 039 ist eine elektronische Schaltung zur Überwachung des Endverstärkers sowie des Magnetventils bekannt, wobei ein Verbindungspunkt zwischen Endtransistor und Magnetventil über einen ohmschen Widerstand und einen Umschalter kurzzeitig mit der Betriebsspannung oder mit Masse verbunden wird. Dabei wird aus der Spannung am Verbindungspunkt auf den Zustand geschlossen.

Es sind bereits Kraftfahrzeug-Regelungssysteme, wie Antiblokkiersystem (ABS), Antriebsschlupfregelungen (ASR), Fahrstablitätsregelungen (FSR, ASMS) usw. bekannt, die Steuerschaltungen enthalten, an die eine größere Anzahl von elektrisch oder elektromagnetisch betätigbaren Hydraulikventilen angeschlossen sind. Die Funktionen solcher Regelungssysteme sind kritisch für die Sicherheit des Fahrzeugs, weil z.B. durch ein ABS in einer Notsituation oder bei einer Panikbremsung der Bremsdruck reduziert wird, um ein Blockieren der Räder zu verhindern, und damit die Bremsfunktion zeitweise aufgehoben oder verringert wird. Solche sicherheitskritischen Systeme und ihre hydraulischen und elektronischen Komponenten, zu denen Steuerschaltungen der hier in Rede stehenden Art zählen, müssen natürlich ständig auf ordnungsgemäße Funktion überwacht werden.

Solche elektrisch ansteuerbaren Hydraulikventile stellen für die zugehörige Steuerschaltung induktive Lasten dar. Die Steuerschaltungen enthalten Endstufen in Form von Treibertransistoren und dergleichen, die ein- und ausgeschaltet werden können und dadurch den Stromfluß durch das Hydraulikventil bestimmen. Beim Sperren des Treibertransistors tendiert bekanntlich die in der induktiven Last, nämlich in der Spule des Hydraulikventils, gespeicherte Energie zur Aufrechterhaltung des Spulenstroms, weshalb, um die Abschaltspannung zu begrenzen, parallel zu der Spule ein Weg für den Abschalt- bzw. Freilaufstrom geschaffen werden muß.

Durch getaktete Ansteuerung des Treibertransistors bzw. der Endstufen und Ausnutzen des Freilaufstromes kann der Mittelwert des bei eingeschaltetem Ventil fließenden Stromes auf einen vorgegebenen Wert begrenzt werden, wenn Taktdauer und Taktpause entsprechend aufeinander abgestimmt sind. Anders ausgedrückt: Durch das getaktete Ansteuern des Treibertransistors, Schließen des Schalters in dem zur induktiven Last parallelen Schaltungszweig während der Sperrintervalle des Treibertransistors und Modulieren des Puls-/Pulspausenverhältnisses des Ansteuertaktes läßt sich ein vorgegebener Strommittelwert einstellen. Die Ansprechschwellen zum Umschalten des Ventils und der anschließende Haltestrom können verschiedene Werte annehmen; das Absenken des Ventilstroms nach dem Ansprechen bzw. Umschalten des Ventils führt zu einer erheblichen Energieinsparung. Bei solchen Systemen ist es jedoch erforderlich, die Einhaltung der ausreichenden Stromwerte - sowohl des Ansprechstromes als auch des Haltestromes - sorgfältig zu überwachen, um mit der gebotenen Sicherheit Fehler, auch "schleichende" Defekte durch Änderung der Referenzspannungswerte etc., rechtzeitig zu erkennen.

Der Erfindung liegt nun die Aufgabe zugrunde, ein Verfahren zu entwickeln, mit dem bei derartigen Steuerschaltungen die Funktion und die ordnungsgemäße Arbeitsweise, das Einhalten der verschiedenen Stromwerte oder Schwellenwerte mit hoher Zuverlässigkeit überwacht werden kann.

Es hat sich herausgestellt, daß diese Aufgabe durch das im Anspruch 1 beschriebene Verfahren zu lösen ist. Mehrere besonders vorteilhafte Ausführungsbeispiele und Schaltungsanordnungen zur Durchführung des Verfahrens sind ebenfalls in den Ansprüchen genannt.

Das Besondere des erfindungsgemäßen Verfahrens besteht drin, daß bei einem Überwachungsverfahren für eine Steuerschaltung der eingangs genannten Art der durch den Energieabbau in den induktiven Lasten, nämlich in den Wicklungen der Hydraulikventile, hervorgerufene Abschalt- oder Freilaufstrom zumindest teilweise oder über eine bestimmte Zeitspanne zu einer gesonderten Strommeßeinrichtung umgeleitet und zur Überprüfung der Endstufe, einschließlich der Last, ausgewertet wird. Insbesondere ist vorgesehen, die einzelnen Endstufen durch Umleitung des jeweiligen Abschalt- oder Freilaufstromes zu einer gemeinsamen Strommeßeinrichtung nacheinander zu überprüfen oder zu testen.

Bei einer Steuerschaltung, an die als induktive Lasten elektrisch betätigbare Hydraulikventile angeschaltet sind, wird gemäß einem vorteilhaften Ausführungsbeispiel das Einhalten vorgegebener Stromwerte, z.B. des Ventil-Ansprechstromes und des Ventil-Haltestromes, in separaten Meßvorgängen überprüft.

Die Reihenfolge des Überprüfens und Testens der einzelnen Endstufen und Stromschwellenwerte wird vorteilhafterweise mit Hilfe einer Zusatzschaltung festgelegt, wobei erst nach dem Überprüfen und Testen aller Endstufen und aller Stromschwellenwerte das Überprüfen und Testen wiederholt wird. Allerdings ist es auch möglich, bestimmten, für die Funktionssicherheit besonders wichtigen Endstufen und Schwellenwerten bei den Testvorgängen Priorität einzuräumen.

Weitere Merkmale, Vorteile und Anwendungsmöglichkeiten der Erfindung gehen aus den folgenden Erläuterungen von Details und Ausführungsbeispielen der Erfindung anhand der beigefügten Darstellungen hervor.

Es zeigen
- Fig. 1: schematisch ein Regelungssystem mit einer Steuerschaltung der hier in Rede stehenden Art,
- Fig. 2: in Blockdarstellung einen Endstufenbaustein für das Regelungssystem nach Fig. 1,
- Fig. 3: im Flow-Chart einen Schritt bei der Äuswahl der Stromtests,
- Fig. 4: ein Beispiel der Prioritätenvergabe,
- Fig. 5: im Diagramm einen Ausschnitt aus dem Stromverlauf bei getakteter Ansteuerung der Endstufen,
- Fig. 6: in Prinzipdarstellung die Erzeugung von Stromreferenzwerten und
- Fig. 7: ein Beispiel für die Anschaltung der gemeinsamen Strommeßeinrichtung an den Leistungstreiber.

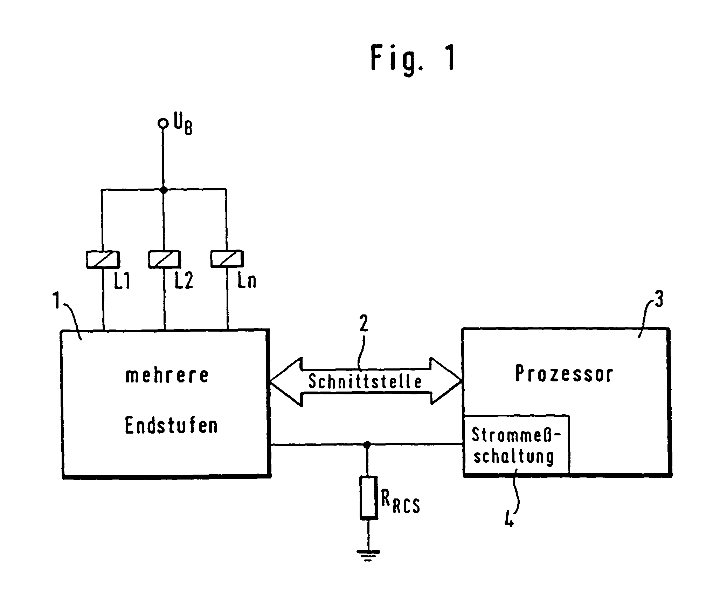

Bei dem Ausführungsbeispiel der Erfindung nach Fig. 1 ist ein Endstufenbaustein 1 über eine Schnittstelle 2 mit einem Prozessor oder Microprozessor 3 verbunden. Der Endstufenbaustein 1 enthält eine größere Anzahl nicht gezeigter Endstufen in Form von Treibertransistoren oder dergl., die induktive Lasten, beispielsweise die Wicklungen oder Spulen von Hydraulikventilen L1,L2,Ln ansteuern. Symbolisch dargestellt ist in Fig. 1 der positive Pol einer Versorgungsspannung U_{B}, worunter bei einem Kraftfahrzeug ein zu der Fahrzeugbatterie führender Anschluß zu verstehen ist.

Die Schaltung nach Fig. 1 enthält außerdem eine Strommeßschaltung 4, die hier als Bestandteil des Prozessors 3 dargestellt ist, jedoch auch durch einen separaten Baustein verwirklicht werden kann. Diese Strommeßschaltung 4 mißt die über einen ohmschen Meßwiderstand R_{RCS} abfallende Spannung. In der nachfolgend im Detail beschriebenen Weise werden die zu messenden bzw. zu überwachenden Ströme mit Hilfe einer zu dem Endstufenbaustein 1 gehörenden Überwachungsschaltung zu dem Meßwiderstand R_{RCS} geleitet. Die Höhe der über dem Meßwiderstand abfallenden Spannung wird dann mit Hilfe der Strommeßeinrichtung 4 (bzw. Spannungsmeßeinrichtung) erfaßt und ausgewertet.

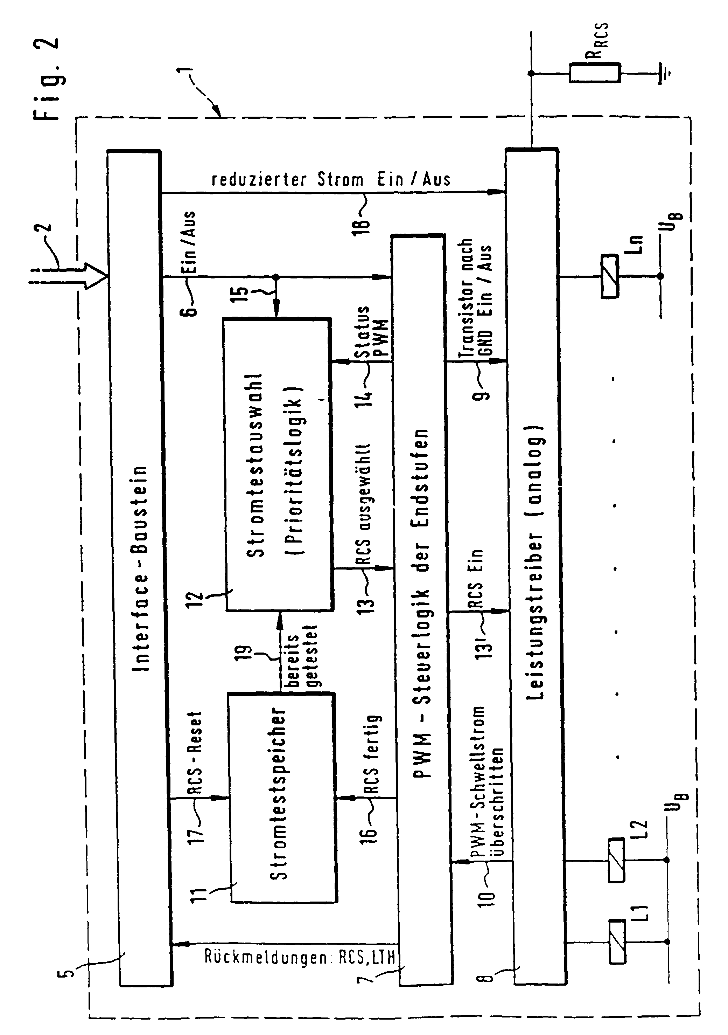

Einzelheiten des Endstufenbausteins 1 sind in Fig. 2 dargestellt.

Ein Schnittstellen-Baustein 5, auch Interface-Baustein genannt, empfängt die von dem Prozessor 3 über die Schnittstelle 2 (siehe Fig. 1) übertragenen Informationen zum Ein- und Ausschalten der induktiven Lasten bzw. Hydraulikventile L1,L2,Ln. Eine Signalleitung 6 im Inneren des Endstufenbausteins 1 leitet die Ein- und Ausschaltbefehle zu einer Steuerlogik 7 weiter. Es handelt sich im dargestellten Ausführungsbeispiel um eine Schaltung mit getakteter (PWM, d.h. pulsweitenmodulierter) Ansteuerung der Leistungstreiber oder Leistungstransistoren, die hier in einem Schaltblock 8 untergebracht sind und die die eigentlichen Endstufen des Endstufenbausteins 1 darstellen. Von den Leistungstreibern im Baustein 8 werden dann direkt die induktiven Lasten bzw. die Hydraulikventile L1,L2,Ln angesteuert.

Von der PWM-Steuerlogik 7 führt eine Signalleitung oder ein Signalbus 9, über den die An- und Abschaltbefehle übertragen werden, zu dem Leistungstreiber-Block 8. Über eine von dem Leistungstreiber-Block 8 zu der Steuerlogik 7 führende Leitung 10 erfolgt eine Rückmeldung an die Steuerlogik 7, sobald ein PWM-Schwellenstrom, d.h. ein vorgegebener Schwellenwert des nach dem Einschalten einer Spule bzw. einer induktiven Last ansteigenden Erregerstromes erreicht oder überschritten wird. Daraufhin wird dann in bekannter Weise der betreffende Leistungstreiber oder Leistungstransistor gesperrt und über einen zu der induktiven Last parallelen Strompfad, in dem sich ein Schalter bzw.-Schaltertransistor befindet, der Abschalt- oder Freilaufstrom geleitet. Nach einer bestimmten Zeitspanne wird dann der Leistungstreiber wieder eingeschaltet, um den durch die Spule des Hydraulikventils schließenden Erregerstrom auf einem mittleren Niveau zu halten. Diese Art der geregelten Ansteuerung von induktiven Lasten durch getaktetes Ein- und Ausschalten der Leistungstreiber ermöglicht eine Begrenzung des Erregerstroms auf einem gerade ausreichenden Wert und führt zu erheblicher Energieeinsparung.

Der Endstufenbaustein 1 nach Fig. 2 enthält außerdem einen sogen. Stromtestspeicher 11 und eine Stromtestauswahlschaltung oder Prioritätslogik 12. Die Auswahlschaltung 12 legt fest, welche Endstufe und welche Stromschwelle als nächstes überprüft oder getestet werden soll. Über eine Signalleitung 13,13' wird die ausgewählte Endstufe an die Strommeßeinrichtung, die aus dem Meßwiderstand R_{RCS} und der Strommeßschaltung 4 besteht, angeschaltet. Dabei wird von der Auswahlschaltung 12 der "Status" der PWM-Ansteuerung berücksichtigt, weshalb die Auswahlschaltung 12 entsprechende Informationen über den PWM-Status über eine Leitung 14 erhält. Die durch die Regelung ausgelöste Ansteuerung der Ventile spielt natürlich ebenfalls eine Rolle, weshalb die Auswahlschaltung 12 über eine Leitung 15 an die Leitung 6 und damit an den Interface-Baustein 5 angeschlossen ist.

In dem Stromtestspeicher 11 wird festgehalten, welche Endstufe und welcher Stromschwellenwert bereits überprüft oder getestet wurde. Die benötigten Informationen enthält der Speicher 11 von der Steuerlogik 7 über eine Leitung 16. Ein Reset des Speichers 11 und damit eine Initialisierung eines erneuten Prüf- und Testvorgangs wird über eine Leitung 17 über den Interface-Baustein 5 zu bestimmten Zeitpunkten - z.B. nach vollständiger Durchführung aller Prüf- und Testvorgänge oder nach Durchführung der wichtigsten Vorgänge - ausgelöst.

Eine wesentliche Maßnahme nach einem Ausführungsbeispiel des erfindungsgemäßen Verfahrens besteht darin, daß nicht nur die Stromwerte bzw. das Erreichen der vorgegebenen Stromschwellenwerte beim Ansteuern der Hydraulikventile L1,L2,Ln überwacht werden, sondern daß auch Stromtests mit reduzierten Ventil-Ansteuerströmen durchgeführt werden. Hierzu werden die induktiven Lasten bzw. die Ventile für vorgegebene Zeitspannen oder mit begrenzten Stromwerten angesteuert, die unterhalb der Ventilreaktion- oder ansprechzeiten liegen und die Ventilströme hervorrufen, die wesentlich kleiner als die im Normalbetrieb benötigten Ventilströme sind. Diese verringerten Ströme oder Teilströme dienen lediglich zum Testen des Endstufenbausteins und der Reaktion der einzelnen Stufen auf die Ansteuersignale.

Für dieses Testverfahren wird über eine leitung 18, die von dem Interface-Baustein 5 zu den Leistungstreibern 8 führt, ein Strom-Ein/Aus-Befehl gegeben, bei dem der Ventilstrom nur bis zu einem vorgegebenen Prüf-Schwellenwert ansteigt und dann im gleichen Verhältnis wie bei einer Regelung im Normalbetrieb reduziert und wieder erhöht wird. Das Ganze spielt sich unterhalb der Ventilreaktionszeiten ab. Jede Endstufe und jede Stromschwelle wird auf diese Weise getestet. Werden die Hydraulikventile mit unterschiedlichen Ansprech- und Halteströmen betrieben, wird auch dies beim Test berücksichtigt.

Von dem Leistungstreiber-Baustein 8 werden innerhalb der Prüf- und Testvorgänge die Abschalt- oder Freilaufströme zeitweise zu dem Meßwiderstand R_{RCS} (siehe Fig. 1) geleitet, so daß der Spannungsabfall über diesem Meßwiderstand R_{RCS} in der Strommeßschaltung ausgewertet werden kann.

Der Interface-Baustein 5 nach Fig. 2 empfängt also die vom Prozessor 3 über die Schnittstelle 2 gesendeten Informationen zum Ein- und Ausschalten der induktiven Lasten L1,L2,Ln. Gleichzeitig erfolgt über die Schnittstelle 2 und Baustein 5, wenn Stromtests durchgeführt werden sollen, die Initialisierung der Stromtests durch das RCS-Reset. Nach dieser Initialisierung laufen, unter der Voraussetzung, daß die Ventile eingeschaltet werden, die Stromtests automatisch ab. Der RCS-Reset setzt alle Register des Stromtest-Speichers 11 auf Null. Im Stromtest-Speicher wird festgehalten, welcher Stromtest bereits durchgeführt wurde. Während der Durchführung eines Stromtests oder nach abgeschlossenem Stromtest erhält der Stromtest-Speicher über die Leitung 16 Informationen darüber, um welchen Stromtest es sich gehandelt hat. Es ist möglich, gleichartige Stromtests mehrmals oder nur einmalig nach einer Stromtest-Initialisierung durchzuführen.

Die Prioritätslogik 12 verarbeitet sowohl die Informationen über die bereits durchgeführten Stromtests, die ihr über eine Leitung 19 zugeführt werden, bzw. über noch ausstehende Stromtests, als auch Informationen über den Status der Endstufen-Stromregelung, die von der PWM-Steuerlogik über die Leitung 14 zur Verfügung gestellt werden. Mit Hilfe dieser Informationen wählt die Prioritätslogik 12 den als nächsten durchzuführenden Stromtest aus. Jeder mögliche Stromtest hat eine bestimmte Priorität. Die Stromtests, für deren Durchführung die kürzeste Zeit während eines Regelzyklus des Endstufen-Bausteins zur Verfügung steht oder für Bausteine, deren Funktion am wichtigsten ist für die Funktionstüchtigkeit des Endstufen-Bausteins 1, erhalten die höchste Priorität. Ist ein Stromtest ausgewählt, so wird bei dem hier beschriebenen Ausführungsbeispiel als Testzeitpunkt ein bestimmter Zeitabschnitt während der Freilaufphase des Spulenstroms nach dem Sperren der Endstufe ausgewählt und der Test durchgeführt. Nach Beendigung des Tests wird dem Speicher mitgeteilt, um welchen Stromtest es sich gehandelt hat.

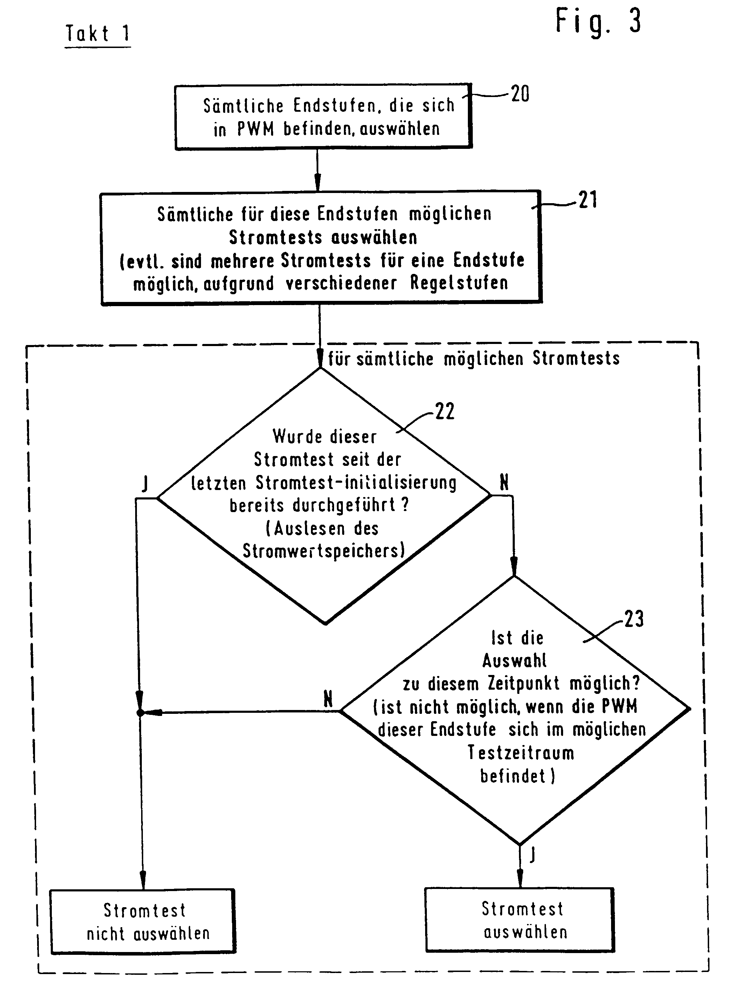

Das Flow-Chart nach Fig. 3 veranschaulicht ein Beispiel für die Funktionsweise bzw. Verknüpfung der Informationen in der Stromtestauswahlschaltung 12. Im Schritt 20 werden zunächst sämtliche Endstufen, die sich in der Regelung befinden, erfaßt. Für jede Endstufe gilt es, mehrere Stromschwellenwerte zu überwachen bzw. mehrere Stromtests durchzuführen (21). Die Entscheidung 22 hängt davon ab, ob der jeweilige Stromtest seit dem letzten Reset bereits durchgeführt wurde oder noch nicht. Wenn nicht, gilt es im Schritt 23 zu überprüfen, ob dieser noch nicht durchgeführte Stromtest zum aktuellen Zeitpunkt möglich ist.

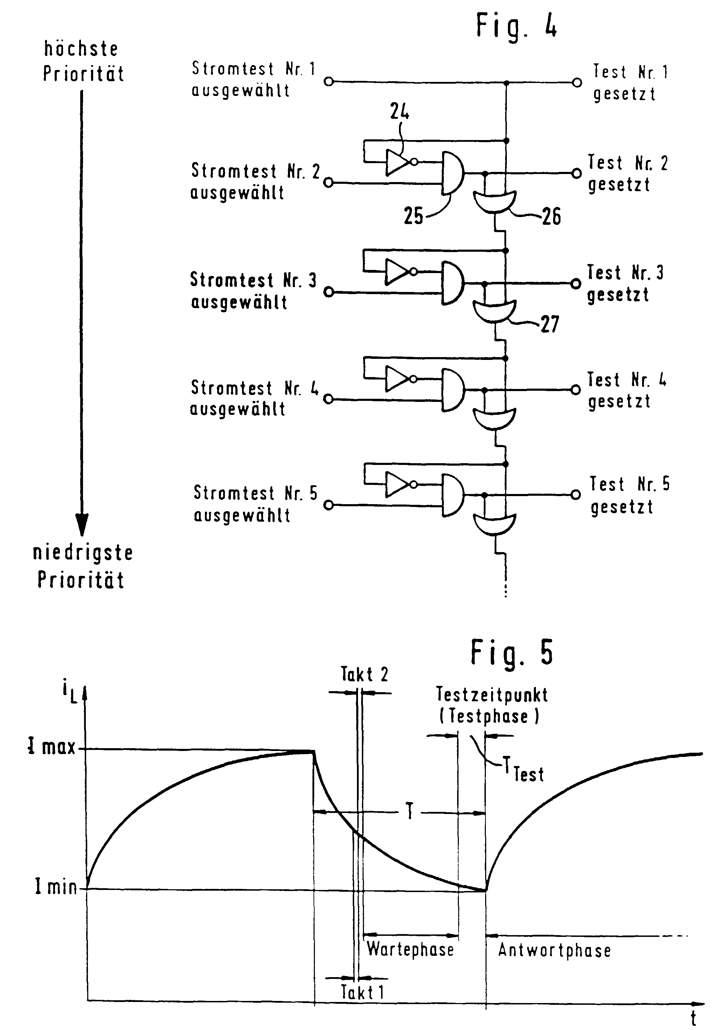

Von den im Entscheidungsprozeß nach dem Flow-Chart gemäß Fig. 3 ausgewählten Stromtests wird nun derjenige bestimmt, der die höchste Priorität hat. Ein Beispiel für eine Prioritätvorgabe bzw. für eine Logikschaltung zur Definition des Prioritätsrangs zeigt Fig. 4. In dem dargestellten Beispiel hat der Stromtest Nr. 1 die höchste, der Stromtest Nr. 5 die geringste Priorität. Wird beispielsweise der Stromtest Nr. 1 ausgewählt, entsteht eine '1' am Testausgang Nr. 1. Durch einen Inverter 24 und ein UND-Gatter 25 ist sichergestellt, daß am Testausgang Nr. 2 auch bei Auswahl des Stromtests Nr. 2 die '0' erhalten bleibt. Mit Hilfe eines ODER-Gatters 26 wird erreicht, daß bei Auswahl des Stromtests Nr. 1 auch alle anderen Testausgänge auf dem Signal-Niveau '0' bleiben.

Wäre bei einem anderen Beispiel der Stromtest Nr. 3 ausgewählt worden, hätte dies zu einem '1' am Testeingang Nr. 3 geführt, während die nachfolgenden Testausgänge (Nr. 4 und Nr. 5) in der entsprechenden Weise gesperrt würden.

Die Wahl des Zeitpunktes bzw. der Zeitspanne, hier "Testphase" genannt, während der der zu messende Strom über den Meßwiderstand R_{RCS} geleitet und die über diesen Meßwiderstand abfallende Spannung ausgewertet wird, veranschaulicht Fig. 5. Dargestellt ist ein Ausschnitt aus dem Verlauf des durch die induktive Last L1,L2,Ln fließenden Stromes i_{L} bei einer getakteten Ansteuerung der Endstufe. Sobald der Strom i_{L} einen vorgegebenen Maximalwert Imax erreicht - oder nach einer bestimmten Zeitspanne -, wird der Treibertransistor der Endstufe gesperrt, worauf anschließend infolge der in der Spule bzw. in der Induktivität gespeicherten Energie ein Abschalt- oder Freilaufstrom hervorgerufen wird. Nach einer bestimmten Zeitspanne oder nach Abfall des Stromes i_{L} auf einen vorgegebenen Wert Imin wird der Treibertransistor der Endstufe erneut auf Durchlaß geschaltet. Dieser Wechsel wird bis zur Abschaltung des entsprechenden Hydraulikventils fortgesetzt. In einem anderen, hier nicht näher beschrieben Ausführungsbeispiel wird der Erregerstrom nach dem Ansprechen der Spule auf einen Haltestrom herabgesetzt und dieser Haltestrom dann durch die Taktung auf einem Mittelwert gehalten.

Der Stromverlauf nach Fig. 5 zeigt bei Ansteuerung eines Hydraulikventils bis zum sicheren Erreichen des Ansprechwertes Imax und anschließendem Absenken in der Freilaufphase auf Imin die gleichen Proportionen wie bei einem Ansteuern dieses Ventils durch einen reduzierten Teststrom, bei dem das Ventil nicht ansprechen darf. Die Stromschwellenwerte "Imax" und "Imin" zum Testen oder Überprüfen des Ventils liegen lediglich im Normalbtrieb wesentlich höher als im Testbetrieb.

Nach dem Auswählen einer Endstufe für einen Stromtest gemäß Fig. 3 in einem Takt 1, siehe Fig. 5, wird in einem Takt 2 der ausgewählte Stromtest in ein Register übernommen und abgespeichert. In einer anschließenden Wartephase bleibt der während des Taktes 2 festgelegte Stromtest gespeichert. Wird während der Wartephase der zu testende Kanal bzw. die zu testende Endstufe abgeschaltet, so wird der ausgewählte Test verworfen; es wird erneut mit Takt 1 in Abhängigkeit vom PWM-Status und dem Testzeitpunkt ein Stromtest ausgewählt. Im Normalfall, wenn der ausgewählte Kanal wie in dem in Fig. 5 dargestellten Beispiel, eingeschaltet bleibt, wird am Ende der Abschalt- bzw. Freilaufphase der Stromtest durchgeführt; diese Testphase T_{Test} findet also unmittelbar vor dem erneuten Einschalten des Endstufentransistors oder Treibers statt. Die Dauer der Freilaufphase ist durch die PWM-Logik fest vorgegeben, so daß auch der Zeitpunkt für den Beginn der Testphase T_{Test} festliegt.

Wird während der Testphase T_{Test} der im Test befindliche Kanal bzw. die ausgewählte Endstufe abgeschaltet, so wird der Test ordnungsgemäß beendet. Der Test ist in diesem Falle auswertbar.

In der in Fig. 5 angedeuteten Antwortphase werden aus dem Endstufenbaustein über den Interface-Baustein 5 Informationen darüber ausgegeben, um welchen Stromtest es sich gehandelt hat. Für diese Antwortphase ist entweder eine feste Dauer von einigen Millisekunden vorgesehen, oder die Antwortphase dauert bis zum Auslesen der Information. Nach Beendigung der Antwortphase wird erneut mit Takt 1 - siehe Fig. 3 - ein neuer Stromtest ausgewählt.

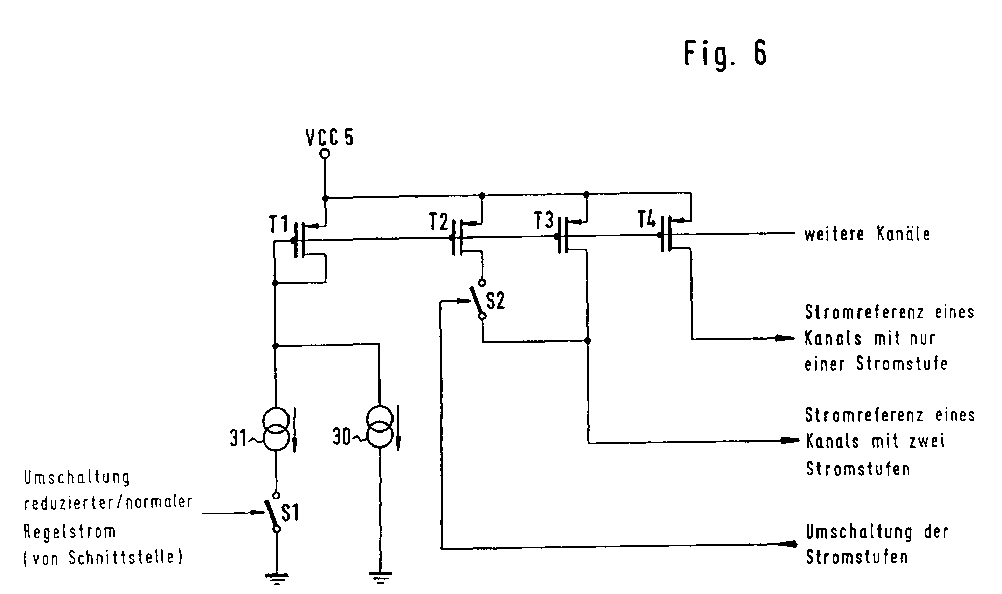

In Fig. 6 ist ein Beispiel einer Schaltungsanordnung dargestellt, mit deren Hilfe es möglich ist, die Funktion der PWM und die Funktion des Stromtests während eines sogen. Stand-By-Betriebes des Endstufenbausteins, d.h. außerhalb einer Regelung, zu überprüfen. Beispielsweise gilt dieser Stand-By-Betrieb bei einem ABS-Regler während des Normalbetriebs des Fahrzeugs, solange keine ABS-Regelung erforderlich ist. Durch dieses Testen im Stand-By-Betrieb wird die volle Funktion der PWM, d.h. der geregelten Ansteuerung der Endstufen bzw. durch die getaktete Einstufung der Endstufen und der Stromtest überwacht. Fehlfunktionen und Defekte werden sehr früh erkannt.

Zur Durchführung dieser Tests werden die induktiven Lasten, wie bereits erwähnt, mit einem reduzierten Regelstrom betrieben. Dieser Regelstrom führt zu keinen mechanischen Reaktionen der induktiven Lasten bzw. der Hydraulikventile; es findet aber dennoch eine lückenlose Stromregelung auf Basis dieser vergleichsweise geringen Testströme statt.

Gleichzeitig mit der Information zum Einschalten der induktiven Lasten wird über die serielle Schnittstelle, z.B. durch ein spezielles Bit oder eine spezielle Bitkombination, die Umschaltung auf reduzierten Regelstrom oder die Umschaltung auf den reduzierten Regelstrom vorgenommen. Wichtig ist hierbei, daß die Zurückschaltung auf den normalen Betriebsstrom kontrolliert wird. Aus diesem Grunde wir nach einem zweckmäßigen Ausführungsbeispiel der Erfindung an nur einer Stelle im Endstufenbaustein die Stromumschaltung vorgenommen. Dann läßt sich durch einen aktiven Testpuls mit Normalstrom an nur einem Lastelement bzw. an nur einem Ventil die Zurückschaltung von dem Prüfstrom auf den Normalstrom überwachen. Da in diesem Falle nur ein Schaltelement zur Umschaltung auf den reduzierten Strom zur Verfügung steht, muß der Regelstrom für sämtliche Endstufen und für sämtliche Stromregelstufen der einzelnen Kanäle um den gleichen Faktor reduziert werden.

Der Endstufenbaustein wird nach Fig. 6 im Stand-By-Betrieb folgendermaßen betrieben:

Nach dem Inbetriebsetzen des Endstufenbausteins, z.B. durch Einschalten der Zündung in einem Kraftfahrzeug, wird mindestens eine Endstufen mit reduziertem Regelstrom eingeschaltet. Dabei erfolgt eine Initialisierung des Stromtests. Der beim Stromtest ermittelte Stromwert wird im Prozessor 3, vgl. Fig. 1, mit dem vorgegebenen Wert für den reduzierten Strom verglichen. Stimmen Sollwert und Istwert nicht überein, liegt ein Fehler vor; es wird eine Sicherheitsabschaltung des Systems in die Wege geleitet.

Durch die beschriebenen Maßnahmen wird das ordnungsgemäße Umschalten auf reduzierten Regelstrom, die Funktion der Stromregelung und der Stromtest überwacht.

Anschließend wird mit Hilfe eines aktiven Testpulses mit normalem Regelstrom, also mit einem zum Ansprechen der Ventile ausreichenden Strom, die Rückschaltung von dem reduzierten auf den normalen Regelstrom überprüft. Dazu wird mit initialisierten Stromtests mindestens ein Ventil mit normalem Regelstrom so lange eingeschaltet, bis der Stromtest empfangen wird. Der Prozessor 3 überprüft den empfangenen Stromwert auf Übereinstimmung mit dem Sollwert für normalen Regelstrom. Ist der empfangene Stromwert zu klein, so funktioniert die Rückschaltung auf normalen Regelstrom nicht. Es erfolgt dann eine Sicherheitsabschaltung. Ist der empfangene Stromwert außerhalb der Toleranz oder bleibt innerhalb eines definierten Zeitraums der Stromtest aus, so ist anzunehmen, daß entweder die Stromregelung oder die Stromtests bei normalem Strom nicht funktionieren. Auch dies hat daher eine Sicherheitsabschaltung zur Folge.

Im Laufe des anschließenden Stand-By-Betriebes des Endstufen-bausteins 1 werden zweckmäßigerweise in bestimmten Zeitabständen Stromtests mit reduziertem Regelstrom durchgeführt, um ständig die richtige Funktion der Stromregelung und der Stromtests zu überwachen und um im Fehlerfall das System abzuschalten.

Beim Übergang vom Stand-By-Betrieb in den aktiven Betrieb erfolgt die Rückschaltung auf normalen Regelstrom.

Fig. 6 zeigt ein Beispiel zur Erzeugung der Referenz-Regelströme für den beschriebenen Endstufenbaustein. Mit Hilfe einer Stromquelle 30 wird ein reduzierter Regelstrom für die Stromtests erzeugt, der durch Zuschalten des Stromes einer Stromquelle 31 durch Schließen eines Schalters S1 zu dem vollen, normalen Regelstrom ergänzt werden kann. Durch Stromspiegelung mit Hilfe von Transistoren T1 bis T4 werden die benötigten Referenzwerte erzeugt. T3 liefert eine Stromreferenzwert für eine Endstufe bzw. ein Ventil, das mit zwei Stromstufen - einem Anzugsstromwert und einem Haltestromwert - betrieben wird. Solange ein Schalter S2 geöffnet ist, gilt der geringere Stromreferenzwert, nach dem Schließen des Schalters S2 der höhere Stromreferenzwert. Mit dem Transistor T4 wird die Stromreferenz für einen Kanal bzw. ein Hydraulikventil gewonnen, das nur einen Referenzwert benötigt.

Die mit den Transistoren T2,T3 und T4 nach Fig. 6 erzeugten Stromreferenzwerte ändern sich beim Zuschalten und Abschalten der Stromquelle 31 mit Hilfe des Schalters S1 in gleichem Verhältnis.

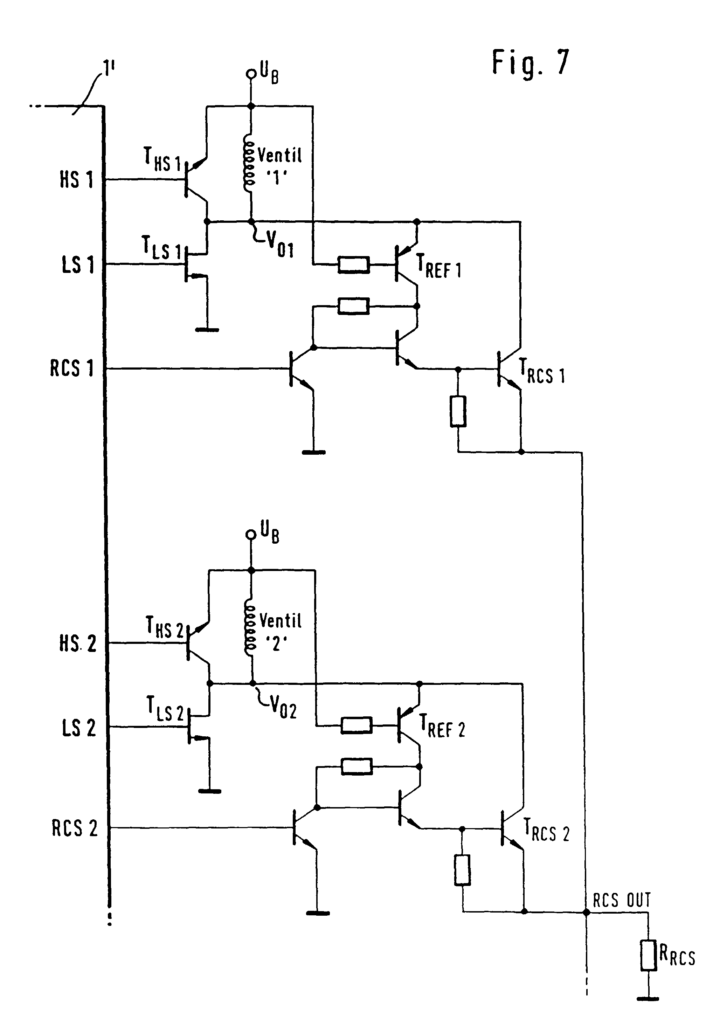

Fig. 7 zeigt ein Beispiel einer Schaltung zur Anschaltung der gemeinsamen Strommeßeinrichtung mit dem Meßwiderstand R_{RCS} an einen Endstufenbaustein 1. Der Endstufenbaustein 1' unterscheidet sich von dem Baustein 1 (Fig. 1 und 2) lediglich durch die separat ausgebildeten, in Fig. 7 dargestellten Anschaltungskomponenten. Nach dem erfindungsgemäßen Verfahren wird nämlich zeitweise, d.h. während der Meß- oder Testphase der Abschalt- oder Freilaufstrom, der beim Abbau der in der induktiven Last gespeicherten Energie hervorgerufen wird, zu dem Meßwiderstand R_{RCS} umgeleitet. Da nach dem erfindungsgemäßen Verfahren dieser Meßwiderstand von allen Endstufen bzw. Ventilen gemeinsam genutzt wird, muß der Strom aller Ventilspulen nacheinander zu dem Anschluß des Meßwiderstandes umgelenkt werden. In Fig. 7 ist für zwei Ventile die zu diesem Zweck verwendete Transistorschaltung dargestellt. Sie arbeitet wie folgt:

Der zu einem zu testenden Ventil '1' gehörende Transistor T_{RCS1} oder zu einem zweiten Ventil '2' gehörende Transistor T_{RCS2} wird zur Umleitung des Freilaufstromes eingeschaltet. Wenn der Stromtest erfolgt, sind sowohl die Transistoren T_{HS1(2)} als auch T_{LS1(2)} gesperrt. Ein Transistor T_{REF1(2)} wird erst dann leitend, wenn und solange die Spannung an einem Knotenpunkt V₀₁₍₂₎ um einen Betrag U_{BE} größer ist als die Spannung U_{B}. Durch diese Maßnahme wird sichergestellt, daß die induktive Last bzw. das Ventil '1'('2') nicht zusätzlich über den Meßwiderstand R_{RCS} gespeist werden kann.

Wenn die Hydrauliventile mit unterschiedlichem Anzugstrom und Haltestrom betrieben werden, muß sichergestellt werden, daß beide Stromschwellen auf das Einhalten von Minimalwerten überprüft werden.

Für jedes Ventil sind gemäß Fig. 7 drei Anschlüsse an die PWM-Steuerlogik bzw. an den Endstufenbaustein 1' vorgesehen. LS1(2) dient zum Einschalten der induktiven Last, HS1(2) zum Ansteuern eines Transistors T_{RS1(2)} in dem Strompfad, der zu der induktiven Last bzw. Ventilspule parallel liegt, und RCS1(2) zum Einschalten der Stromüberwachung oder Stromtestung mit Hilfe des Meßwiderstandes R_{RCS}.

## Patentansprüche

1. Verfahren zur Überwachung einer Steuerschaltung, die eine Vielzahl von induktive Lasten (L1, L2, Ln) schaltende Endstufen (8) aufweist, bei dem der durch die induktive Lasten fließende Strom durch getaktete Ansteuerung der Endstufen (8) geregelt wird, wobei der in den Sperrphasen der Endstufen (8) durch den Abbau der in den induktiven Lasten (L1, L2, Ln) gespeicherten Energie hervorgerufene Strom über einen zu der Last parallelen, einen Schalter enthaltenden Strompfad geleitet wird, wobei der durch den Energieabbau in den induktiven Lasten (L1, L2, Ln) hervorgerufene Abschalt- oder Freilaufstrom zumindest teilweise oder zeitweise zu einer Strommeßeinrichtung (R_{RCS},4) umgeleitet und zur Überprüfung der Endstufe (1,1',8), einschließlich der Last (L1,L2,Ln), ausgewertet wird.

2. Verfahren nach Anspruch 1, dadurch **gekennzeichnet,** daß die einzelnen Endstufen (8) durch Umleitung des Abschaltstroms zu einer gemeinsamen Strommeßeinrichtung (R_{RCs},4) nacheinander überprüft werden.

3. Verfahren nach Anspruch 1 oder 2, dadurch **gekennzeichnet,** daß zur Überwachung einer Steuerschaltung, bei der als induktive Lasten elektrisch betätigbare Hydraulikventile (Ll,L2,Ln) vorgesehen sind, das Einhalten vorgegebener Stromwerte in separaten Meßvorgängen überprüft wird.

4. Verfahren nach Anspruch 3, dadurch **gekennzeichnet,** daß das Einhalten von Minimalwerten des Ventil-Anzugsstroms und/oder des Ventil-Haltestroms überwacht wird.

5. Verfahren nach Anspruch 3, dadurch **gekennzeichnet**, daß die Endstufen (1,1',8), einschließlich der Hydraulikventile (L1,L2,Ln), durch Ansteuern der jeweiligen Endstufe für eine vorgegebene Zeitspanne, die unterhalb der Ventil-Ansprechzeit liegt bzw. in der ein unterhalb des Ventil-Ansprechwertes liegender Ventilstrom (i_{L}) hervorgerufen wird, und Auswerten der Abschalt- bzw. Freilaufströme getestet werden.

6. Verfahren nach Anspruch 5, dadurch **gekennzeichnet,** daß in der Testphase (T_{Test}) die Hydraulikventile (L1,L2,Ln) auf Einhalten eines geregelten Ventil-Teststromes (i_{L}), der auf einen bestimmten Teilwert des Ventil-Ansprechwertes festgelegt wird, und/oder auf Einhalten eines bestimmten Teilwertes des Ventilhaltestromes überwacht werden.

7. Verfahren nach einem oder mehreren der Ansprüche 1 bis 4, dadurch **gekennzeichnet,** daß zur Überprüfung des Ventilansprechstromes der Abschalt- oder Freilaufstrom unmittelbar nach dem Erreichen des Ventil-Ansprechstromes für eine vorgegebene Zeitspanne, nämlich für die Meßzeit, zu der Strommeßeinrichtung umgeleitet wird.

8. Verfahren nach einem oder mehreren der Ansprüche 1 bis 4, dadurch **gekennzeichnet,** daß zur Überwachung des Ventil-Haltestromes der Abschalt- oder Freilaufstrom am Ende einer der Sperrphasen der Endstufe bzw. einer der der Taktpausen während der getakteten Ansteuerung der Endstufe zur Strommeßeinrichtung umgeleitet wird.

9. Verfahren nach einem oder mehreren der Ansprüche 1 bis 8, dadurch **gekennzeichnet,** daß die Reihenfolge des Überprüfens und Testens der einzelnen Endstufen (8) und der verschiedenartigen Stromschwellenwerte mit Hilfe einer Zusatzschaltung (11,12) festgelegt wird, wobei erst nach dem Überprüfen und Testen aller Endstufen (8) und aller Stromschwellenwerte oder bestimmter Endstufen und Schwellenwerte der Überprüfungs- und Testvorgang wiederholt wird.

10. Verfahren nach Anspruch 9, dadurch **gekennzeichnet,** daß die Reihenfolge des Überprüfens und Testens durch eine Prioritätslogik (12) vorgegeben wird.

11. Verfahren nach Anspruch 10, dadurch **gekennzeichnet,** daß die Prioritätsvorgabe in Abhängigkeit von der zu erwartenden Häufigkeit der Ansteuerung des jeweiligen Ventils (L1,L2,Ln) und/oder in Abhängigkeit von der Bedeutung der Endstufe für die Funktion des Systems gewählt wird.

12. Schaltungsanordnung zur Durchführung des Verfahrens nach einem oder mehreren der Ansprüche 1 bis 11, für einen Endstufenbaustein (1, 1'), der eine Steuerschaltung und induktive Lasten (L1, L2, Ln) schaltende Endstufen (8) umfaßt und bei dem den induktiven Lasten (L1, L2, Ln) parallele, mit Schaltern ausgerüstete Strompfade vorgesehen sind, über die beim Sperren der Endstufen (8) infolge der in den induktiven Lasten (L1, L2, Ln) gespeicherten Energie ein Abschalt- oder Freilaufstrom hervorgerufen wird, wobei der Endstufenbaustein (1,1') mit einer separaten oder integrierten Strommeßeinrichtung (R_{RCS},4) ausgerüstet ist und wobei zum Überwachen und/oder Überprüfen (Testen) des Endstufen-bausteins (1,1'), einschließlich der induktiven Lasten (L1, L2, Ln), der Abschalt- oder Freilaufstrom, der in den Sperrphasen der Endstufen durch die in den induktiven Lasten gespeicherten Energie hervorgerufen wird, zumindest teilweise oder zeitweise zu der Strommeßeinrichtung umleitbar ist.

13. Schaltungsanordnung nach Anspruch 12, dadurch **gekennzeichnet,** daß die Schalter in den zu den induktiven Lasten parallelen Strompfaden und die Schaltelemente zur Anschaltung der Strommeßeinrichtung Transistoren sind und daß die Umleitung des in einer Sperrphase einer Endstufe durch die induktive Last hervorgerufenen Stromes durch Sperren des in dem parallelen Strompfad eingefügten Schalttransistors (T_{HS1(2)}) und durch Ansteuern des zur Strommeßeinrichtung führenden Transistors (T_{RCS1(2)}) erfolgt.

14. Schaltungsanordnung nach Anspruch 12 oder 13, dadurch **gekennzeichnet,** daß die Strommeßeinrichtung einen ohmschen Meßwiderstand (R_{RCS}) enthält, über dem in einer Testphase bzw. während der Überprüfung bei ordnungsgemäßer Funktion der Endstufe eine über der Versorgungsspannung (U_{B}) der Steuerschaltung liegende Spannung abfällt.

15. Schaltungsanordnung nach Anspruch 14, dadurch **gekennzeichnet,** daß diese den Spannungsabfall über dem Meßwiderstand (R_{RCS}) auf Einhalten eines unteren und eines oberen Grenzwertes überwacht.

16. Schaltungsanordnung nach einem oder mehreren der Ansprüche 12 bis 15, dadurch **gekennzeichnet**, daß für das Überprüfen und Testen der Endstufen des Endstufenbausteins eine gemeinsame Strommeßeinrichtung (R_{RCS},4) vorgesehen ist, die einen den Abschaltstrom nach Masse ableitenden Meßwiderstand (R_{RCS}) enthält, der zur Überprüfung der Endstufe über eine Transistorschaltung angeschaltet wird, die nur dann stromleitend ist, wenn bei der Sperrung der Endstufe das Potential an der Ventilspule über das durch die Versorgungsspannung vorgegebene Potential ansteigt.

17. Schaltungsanordnung nach einem oder mehreren der Ansprüche 12 bis 16, dadurch **gekennzeichnet,** daß eine Zusatzschaltung (11,12) mit einer Prioritätslogik (12) vorgesehen ist, die die Reihenfolge der Prüf- und Testvorgänge der einzelnen Endstufen festlegt, die den Zeitpunkt der Prüf- und Testvorgänge bestimmt und die diese Vorgänge steuert.

## Claims

1. Method of monitoring a control circuit having a number of output stages (8) switching inductive loads (L1, L2, Ln) wherein the current flowing through the inductive loads is regulated by clocked driving of the output stages (8), and the current generated in the blocked phases of the output stages (8) by the drop in energy stored in the inductive loads (L1, L2, Ln) is conducted over a current path parallel to the load and containing a switch, wherein the cut-off current or free-wheeling current generated by the energy drop in the inductive loads (L1, L2, Ln) is at least partially or temporarily rerouted to a current measuring device (RRCS, 4) and evaluated for the purpose of testing the output stage (1, 1', 8), including the load (L1, L2, Ln).

2. Method according to claim 1, characterized in that the individual output stages (8) are tested in sequence by rerouting the cut-off current to a common current measuring device (R_{RCS}, 4).

3. Method according to claim 1 or 2, characterized in that, for monitoring a control circuit in which electrically operated hydraulic valves (L1, L2, Ln) are provided as inductive loads, the adherence to preset current values is checked in separate measurement operations.

4. Method according to claim 3, characterized in that the adherence to minimum values of the valve start-up current and holding current is monitored.

5. Method according to claim 3, characterized in that the output stages (1, 1', 8), including the hydraulic valves (L1, L2, Ln), are tested by driving the given output stage for a preset period of time which is less than the valve response time or during which a valve current (i_{L}) is generated that is below the valve response value, and by evaluating the cut-off current or free-wheeling current.

6. Method according to claim 5, characterized in that in the test phase (T_{Test}), the hydraulic valves (L1, L2, Ln) are monitored for maintaining a regulated valve test current (i_{L}) which is set at a specified fractional value of the valve response value, and/or for maintaining a specific fractional value of the valve holding current.

7. Method according to one or more of claims 1 through 4, characterized in that for testing the valve response current the cut-off current or free-wheeling current is rerouted to the current measuring device immediately after the valve response current is achieved for a preselected period of time, namely for the measurement period.

8. Method according to one or more of claims 1 through 4, characterized in that for monitoring the valve holding current, the cut-off current or free-wheeling current at the end of one of the blocked phases of the output stage, or at the end of one of the clock pauses during clocked driving of the output stage, is rerouted to the current measuring device.

9. Method according to one or more of claims 1 through 8, characterized in that the sequence of checking and testing the individual output stages (8) and the various current threshold values is determined with the help of a supplementary circuit (11, 12), and only after checking and testing all output stages (8) and all current threshold values or specific output stages and threshold values are the checking and testing processes repeated.

10. Method according to claim 9, characterized in that the sequence of checking and testing is preset by a priority logic unit (12).

11. Method according to claim 10, characterized in that the priority assignment is selected as a function of the expected frequency of the actuation of the given valve (L1, L2, Ln) and/or as a function of the importance of the output stage for the operation of the system.

12. Circuit arrangement for implementing the method according to one or more of claims 1 through 11, for an output module (1, 1') which includes a control circuit and output stages (8) switching inductive loads (L1, L2, Ln), and in this output module current paths are provided that are parallel to the inductive loads (L1, L2, Ln) and fitted with switches, and across these current paths, upon blocking of the output stages (8), a cut-off current or free-wheeling current is generated as a result of the energy stored in the inductive loads (L1, L2, Ln), wherein the output module (1, 1') is fitted with a separate or integrated current measuring device (R_{RCS}, 4), and wherein for monitoring and/or checking (testing) the output module (1, 1'), including the inductive loads (L1, L2, Ln), the cut-off current or free-wheeling current induced in the blocked phases of the output stages due to the energy stored in the inductive loads is at least partially or temporarily reroutable to the current measuring device.

13. Circuit arrangement according to claim 12, characterized in that the switches in the circuit paths that are in parallel to the inductive loads, and the switching elements for switching on the current measuring device are transistors, and in that the rerouting of the current generated in a blocked phase of an output stage by the inductive load is accomplished by blocking the switching transistor (T_{HS1(2)}) located in the parallel current path, and by driving the transistor (T_{RCS1(2)}) leading to the current measuring device.

14. Circuit arrangement according to claim 12 or 13, characterized in that the current measuring device contains an ohmic measuring shunt (R_{RCS}) across which a voltage higher than the supply voltage (U_{B)}) of the control circuit drops in a test phase or while checking for proper functioning of the output stage.

15. Circuit arrangement according to claim 14, characterized in that this voltage drop across the measuring shunt (R_{RCS)}) is monitored as to whether upper and lower limit values are maintained.

16. Circuit arrangement according to one or more of claims 12 through 15, characterized in that, for checking and testing the output stages of the output module, a common current measuring device (RRCS, 4) is provided which contains a measuring shunt (R_{RCS}) that dissipates the cut-off current to ground and is connected by way of a transistor circuit for testing the output stage, and this transistor circuit is conducting only when, during the blocking of the output stage, the potential at the valve coil increases to a magnitude above the potential predetermined by the supply voltage.

17. Circuit arrangement according to one or more of claims 12 through 16, characterized in that a supplementary circuit (11, 12) is provided with a priority logic unit (12) which determines the sequence of the checking and testing operations of the individual output stages and determines the time of the checking and testing procedures and controls these procedures.

## Revendications

1. Procédé de surveillance d'un circuit de commande, qui comprend de multiples étages finals (8) commutant des charges inductives (L1, L2, Ln), selon lequel le courant passant dans les charges inductives fait l'objet d'une régulation au moyen d'une commande par impulsions des étages finals (8), le courant qui, dans les phases de blocage des étages finals (8), est dû à la disparition de l'énergie accumulée dans les charges inductives (L1, L2, Ln) étant envoyé dans un trajet parallèle à la charge et contenant un interrupteur, le courant de coupure ou courant de roue libre dû à la disparition d'énergie dans les charges inductives est dévié, au moins partiellement ou temporairement, vers un dispositif de mesure de courant (R_{RCS}, 4) et est analysé en vue de contrôler les étages finals (1, 1', 8), y compris la charge (L1, L2, Ln).

2. Procédé suivant la revendication 1, caractérisé en ce que les différents étages finals (8) sont contrôlés l'un après l'autre en déviant le courant de coupure vers un dispositif de mesure de courant (R_{RCS}, 4) commun.

3. Procédé suivant la revendication 1 ou 2, caractérisé en ce que, pour la surveillance d'un circuit de commande dans lequel des valves hydrauliques à commande électrique (L1, L2, Ln) sont prévues en tant que charges inductives, le respect de valeurs de courant préfixées est contrôlé dans des opérations de mesure séparées.

4. Procédé suivant la revendication 3, caractérisé en ce que le respect de valeurs minimales du courant d'actionnement de valve et/ou du courant de maintien de valve est surveillé.

5. Procédé suivant'la revendication 3, caractérisé en ce que les étages finals (1, 1', 8), y compris les valves hydrauliques (L1, L2, Ln), sont testés chacun en commandant l'étage final respectif pendant un intervalle de temps préfixé qui est inférieur au temps de réponse de valve ou dans lequel un courant de valve (i_{L}) inférieur à la valeur de réponse de valve est créé, et en analysant les courants de coupure ou courants de roue libre.

6. Procédé suivant la revendication 5, caractérisé en ce que, dans la phase de test (T_{Test}), les valves hydrauliques (L1, L2, Ln) sont surveillées en ce qui concerne le respect d'un courant de test de valve (i_{L}) objet d'une régulation, qui est fixé à une valeur partielle déterminée de la valeur de réponse de valve, et/ou en ce qui concerne le respect d'une valeur partielle déterminée du courant de maintien de valve.

7. Procédé suivant une ou plusieurs des revendications 1 à 4, caractérisé en ce que, pour le contrôle du courant de réponse de valve, le courant de coupure ou courant de roue libre est dévié vers le dispositif de mesure de courant immédiatement après que le courant de réponse de valve est atteint et pour un intervalle de temps préfixé, à savoir pour la durée de mesure.

8. Procédé suivant une ou plusieurs des revendications 1 à 4, caractérisé en ce que, pour la surveillance du courant de maintien de valve, le courant de coupure ou courant de roue libre est dévié vers le dispositif de mesure de courant à la fin de l'une des phases de blocage de l'étage final ou de l'un des intervalles entre impulsions et pendant la commande par impulsions de l'étage final.

9. Procédé suivant une ou plusieurs des revendications 1 à 8, caractérisé en ce que la succession des contrôles et tests des différents étages finals (8) et des valeurs de seuil de courant de types différents est déterminée au moyen d'un circuit supplémentaire (11, 12), l'opération de contrôle et test n'étant répétée qu'après le contrôle et test de tous les étages finals (8) et de toutes les valeurs de seuil de courant ou d'étages finals et de valeurs de seuil déterminés.

10. Procédé suivant la revendication 9, caractérisé en ce que la succession des contrôles et tests est préfixée au moyen d'une logique de priorités (12).

11. Procédé suivant la revendication 10, caractérisé en ce que l'affectation de priorités est choisie en fonction de la fréquence qu'il faut attendre de la commande de chaque valve (L1, L2, Ln) et/ou en fonction de l'importance de l'étage final pour le fonctionnement du système.

12. Agencement de circuit pour la mise en oeuvre du procédé suivant une ou plusieurs des revendications 1 à 11, pour un bloc d'étages finals (1, 1') qui comprend un circuit de commande et des étages finals (8) commutant des charges inductives (L1, L2, Ln) et pour lequel sont prévus des trajets de courant, parallèles aux charges inductives (L1, L2, Ln) et pourvus d'interrupteurs, au moyen desquels un courant de coupure ou courant de roue libre est créé, lors du blocage des étages finals (8), sous l'effet de l'énergie accumulée dans les charges inductives (L1, L2, Ln), dans lequel le bloc d'étages finals (1, 1') est pourvu d'un dispositif de mesure de courant (R_{RCS}, 4) séparé ou intégré et dans lequel, pour la surveillance et/ou le contrôle (test) du bloc d'étages finals (1, 1'), y compris les charges inductives (L1, L2, Ln), le courant de coupure ou courant de roue libre qui est créé, dans les phases de blocage des étages finals, par l'énergie accumulée dans les charges inductives peut être dévié, au moins partiellement ou temporairement, vers le dispositif de mesure de courant.

13. Agencement de circuit suivant la revendication 12, caractérisé en ce que les interrupteurs situés dans les trajets de courant parallèles aux charges inductives et les éléments de commutation servant à la connexion du dispositif de mesure de courant sont des transistors et en ce que la déviation du courant créé par la charge inductive dans une phase de blocage d'un étage final a lieu par blocage du transistor de commutation (T_{HS1(2)}) inséré dans le trajet de courant parallèle et par commande du transistor (T_{RCS1(2)}) menant au dispositif de mesure de courant.

14. Agencement de circuit suivant la revendication 12 ou 13, caractérisé en ce que le dispositif de mesure de courant contient une résistance ohmique de mesure (R_{RCS}) aux bornes de laquelle se présente, dans une phase de test ou pendant le contrôle lors d'un fonctionnement normal de l'étage final, une chute de tension supérieure à la tension d'alimentation (U_{B}) du circuit de commande.

15. Agencement de circuit suivant la revendication 14, caractérisé en ce que celui-ci surveille la chute de tension aux bornes de la résistance de mesure (R_{RCS}) en ce qui concerne le respect d'une valeur limite inférieure et d'une valeur limite supérieure.

16. Agencement de circuit suivant l'une une ou plusieurs des revendications 12 à 15, caractérisé en ce que, pour le contrôle et le test des étages finals du bloc d'étages finals, il est prévu un dispositif de mesure de courant commun (R_{RCS}, 4) qui contient une résistance de mesure (R_{RCS}) qui fait passer le courant de coupure à la masse et qui, pour le contrôle de l'étage final, est connecté au moyen d'un montage de transistors qui n'est conducteur du courant que lorsque, lors du blocage de l'étage final, le potentiel sur la bobine de valve s'élève au-dessus du potentiel préfixé par la tension d'alimentation.

17. Agencement de circuit suivant une ou plusieurs des revendications 12 à 16, caractérisé en ce qu'un circuit supplémentaire (11, 12) est pourvu d'une logique de priorités (12) qui établit la succession des opérations de contrôle et de test des différents étages finals, qui détermine l'instant des opérations de contrôle et de test et qui commande ces opérations.
